# EUROPEAN PATENT SPECIFICATION

(11) **EP 1 143 466 B1**
(45) Date of publication and mention of the grant of the patent: **05.11.2003**
(21) Application number: 01302513.5
(22) Date of filing: 19.03.2001
(51) Int. Cl.: H01H 1/00, H01H 37/76

(54) **Lockable microelectromechanical actuators using thermoplastic materials, and methods of operating same**
Feststellbare mikroelektromechanische Betätigungsvorrichtung unter Verwendung von thermoplastischem Material, und Verfahren zu seiner Betätigung
Dispositif de commande microélectroméchanique verrouillable utilisant des matières thermoplastiques, et procédé pour son fonctionnement

(30) Priority: 05.04.2000 US 543540
(43) Date of publication of application: 10.10.2001
(73) Proprietor: Memscap S.A., 38926 Crolles Cedex (FR)
(72) Inventor: Wood, Robert L., Cary, North Carolina 27502 (US)
(74) Representative: McKechnie, Neil

(56) References cited:
- US-A- 4 203 086
- US-A- 5 994 816

## Description

### Field of the Invention

This invention relates to electromechanical systems, and more particularly to microelectromechanical systems and operating methods therefor.

### Background of the Invention

Microelectromechanical systems (MEMS) have been developed as alternatives to conventional electromechanical devices, such as relays, actuators, valves and sensors. MEMS devices are potentially low-cost devices, due to the use of microelectronic fabrication techniques. New functionality also may be provided, because MEMS devices can be much smaller than conventional electromechanical devices.

Many applications of MEMS technology use MEMS actuators. These actuators may use one or more beams that are fixed at one or both ends. These actuators may be actuated electrostatically, magnetically, thermally and/or using other forms of energy.

A major breakthrough in MEMS actuators is described in U.S. Patent 5,909,078 entitled *Thermal Arched Beam Microelectromechanical Actuators* to the present inventor et al., the disclosure of which is hereby incorporated herein by reference. Disclosed is a family of thermal arched beam microelectromechanical actuators that include an arched beam which extends between spaced apart supports on a microelectronic substrate. The arched beam expands upon application of heat thereto.

Means are provided for applying heat to the arched beam to cause further arching of the beam as a result of thermal expansion thereof, to thereby cause displacement of the arched beam.

Unexpectedly, when used as a microelectromechanical actuator, thermal expansion of the arched beam can create relatively large displacement and relatively large forces while consuming reasonable power. A coupler can be used to mechanically couple multiple arched beams. At least one compensating arched beam also can be included which is arched in a second direction opposite to the multiple arched beams and also is mechanically coupled to the coupler. The compensating arched beams can compensate for ambient temperature or other effects to allow for self-compensating actuators and sensors. Thermal arched beams can be used to provide actuators, relays, sensors, microvalves and other MEMS devices. Thermal arched beam microelectromechanical devices and associated fabrication methods also are described in U.S. Patent 5,955,817 to Dhuler et al. entitled *Thermal Arched Beam Microelectromechanical Switching Array*; U.S. Patent 5,962,949 to Dhuler et al. entitled *Microelectromechanical Positioning Apparatus*; U.S. Patent 5,994,816 to Dhuler et al. entitled *Thermal Archer Beam Microelectromechanical Devices and Associated Fabrication Methods* and defining the closest prior art; and U.S. Patent 6,023,121 to Dhuler et al. entitled *Thermal Arched Beam Microelectromechanical Structure.* .

Unfortunately, conventional MEMS actuators may require continuous application of an electrostatic potential, a magnetic field, electric current and/or other energy to the MEMS actuator in order to maintain the actuator in a set or actuated position. This may consume excessive power. Moreover, an interruption of power may cause the actuator to reset.

It is known to provide notches, dimples, protrusions, indentations and/or other mechanical features in MEMS actuators that can allow the actuator to be mechanically set in a given position. See for example, the above-cited U.S. Patents 5,955,817 and 5,994,816. Unfortunately, these mechanical features may be subject to wear. Moreover, mechanical locking that relies on friction may be difficult to obtain reliably due to the small dimensions of MEMS actuators and the uncertain values of static and dynamic friction in MEMS devices. Thus, notwithstanding conventional microelectromechanical devices, there continues to be a need for lockable microelectromechanical actuators that need not consume power when locked and need not rely on mechanical friction for locking.

### Summary of the Invention

Lockable microelectromechanical actuators according to embodiments of the invention include a microelectromechanical actuator, a thermoplastic material that is coupled to the microelectromechanical actuator to lock the microelectromechanical actuator, and a heater that melts the thermoplastic material to allow movement of the microelectromechanical actuator. When the thermoplastic material solidifies, movement of the microelectromechanical actuator can be locked, without the need to maintain power, in the form of electric, magnetic and/or electrostatic energy, to the microelectromechanical actuator, and without the need to rely on mechanical friction to hold the microelectromechanical actuator in place. Thus, the thermoplastic material can act as a glue to hold structures in a particular position without the need for continuous power application. Moreover, it has been found unexpectedly, that the thermoplastic material can solidify rapidly enough to lock the microelectromechanical actuator at or near its most recent position.

Embodiments of the present invention preferably are formed on a substrate, wherein the heater is on the substrate and wherein a portion of the microelectromechanical actuator is adjacent and spaced apart from the heater, and wherein the thermoplastic material is between the heater and the portion of the microelectromechanical actuator. The microelectromechanical actuators may move along the substrate to provide embodiments of "in-plane" microelectromechanical actuators. Alternatively, the actuators may move out of the plane of the substrate, for example, orthogonal to the substrate, to provide embodiments of "out-of-plane" microelectromechanical actuators.

Embodiments of the present invention may be used with actuators that are actuated using electrostatic, magnetic, thermal and/or other forms of actuation. In embodiments of thermally actuated microelectromechanical actuators, the heater that melts the thermoplastic material also may be used to actuate the thermally actuated microelectromechanical actuator. In alternative embodiments, the heater that melts the thermoplastic material is a first heater and the lockable microelectromechanical actuator also includes a second heater that is thermally coupled to the microelectromechanical actuator, such that the microelectromechanical actuator moves in response to actuation of the second heater. Embodiments of lockable microelectromechanical actuators that employ first and second heaters also may include a thermal isolator that is configured to isolate the second heater from the thermoplastic material.

In embodiments of the present invention that use the same heater to melt the thermoplastic material and to actuate the thermal actuator, the heater may be configured to melt the thermoplastic material and actuate the thermal actuator upon application of a first amount of power thereto. The heater also may be configured to melt the thermoplastic material without actuating the thermal actuator upon application of second amount of power thereto that is less than the first amount of power. Unexpectedly, it has been found that the actuator can be restored to its starting or unactuated position by applying sufficient power to the heater to melt the thermoplastic material, but not enough power to actuate the actuator. With the thermoplastic material melted, viscous flow can occur and permit the actuator to relax back to its neutral position. Thus, a reversible system may be provided, that can allow continuous variability and simple control setup.

Thermoplastic materials according to the present invention may include thermoplastic polymers, thermoplastic monomers, solders and/or any other material that changes from a solid to a liquid material over a temperature range that is compatible with the ambient temperature in which the lockable microelectromechanical actuator will be used. Embodiments of lockable microelectromechanical actuators according to the invention may be combined with a relay contact, an optical attenuator, an optical switch, a variable circuit element such as a variable resistor, a valve, a circuit breaker and/or other elements to provide a microelectromechanical device.

Other embodiments of the invention provide lockable thermal arched beam microelectromechanical actuators. Embodiments of thermal arched beam microelectromechanical actuators include a substrate, spaced apart supports on the substrate and an arched beam that extends between the spaced apart supports, and that further arches upon application of heat thereto for movement along the substrate. A thermoplastic material is coupled to the arched beam to lock the arched beam. A heater melts the thermoplastic material to allow movement of the arched beam. In preferred embodiments, the heater is on the substrate, the arched beam is adjacent and spaced apart from the heater, and the thermoplastic material is between the heater and the arched beam.

Embodiments of lockable thermal arched beam microelectromechanical actuators use the heater both to further arch the arched beam and to melt the thermoplastic material. Alternative embodiments use a first heater to melt the thermoplastic material and a second heater that is thermally coupled to the arched beam to further arch the arched beam. These alternative embodiments also may include a thermal isolator that is configured to thermally isolate the second heater from the thermoplastic material.

As was described above, in embodiments of lockable thermal arched microelectromechanical actuators wherein a single heater is used, the heater may be configured to melt the thermoplastic material and to further arch the arched beam upon application of a first amount of power thereto. The heater also may be configured to melt the thermoplastic material without further arching the arched beam upon application of a second amount of power thereto that is less than the first amount of power. Embodiments of lockable thermal arched beam microelectromechanical actuators can use the thermoplastic materials selected that were described above, and can be combined with other elements as was described above.

Other embodiments of lockable thermal arched beam microelectromechanical actuators use first and second parallel arched beams that further arch upon application of heat thereto. A coupler is attached to the first and second arched beams, such that the first and second arched beams move in tandem along the substrate upon application of heat thereto. In these embodiments, the thermoplastic material may extend between the coupler and the heater. The coupler may include an aperture that extends therethrough from opposite the heater to adjacent the heater and that is configured to allow placement of the thermoplastic material between the coupler and the heater.

Microelectromechanical actuators may be operated, according to embodiments of the present invention, by melting a thermoplastic material that is coupled to the microelectromechanical actuator to unlock the microelectromechanical actuator. The unlocked microelectromechanical actuator may be actuated. The melted thermoplastic material then may be allowed to solidify to lock the microelectromechanical actuator. In embodiments of these methods, the melting and actuating may be performed simultaneously. In other embodiments, melting of the thermoplastic material is performed by applying power to a heater that is thermally coupled to the thermoplastic material. The melted material is solidified by removing the power from the heater.

In alternative embodiments of methods according to the present invention, the microelectromechanical actuator is a thermally actuated microelectromechanical actuator wherein the heater also is thermally coupled to the thermally actuated microelectromechanical actuator. Power is applied to the heater to actuate the thermally actuated microelectromechanical actuator. Melting and actuating may be performed simultaneously by applying power to the heater.

In alternate embodiments of methods according to the present invention wherein the microelectromechanical actuator includes a first heater that is thermally coupled to the thermoplastic material and includes a second heater that is thermally coupled to the thermally actuated microelectromechanical actuator, melting may be performed by applying power to the first heater to melt the thermoplastic material. Actuating may be performed by applying power to the second heater, to actuate the thermally actuated microelectromechanical actuator. Power then may be removed from the heater, to allow the melted thermoplastic material to solidify.

In all of the above method embodiments, the step of allowing the melted thermoplastic material to solidify may be followed by again melting the thermoplastic material to again unlock the microelectromechanical actuator. The microelectromechanical actuator then can return to its neutral or retracted position. Thus, by melting the thermoplastic material, the microelectromechanical actuator can be unlocked and deactuated.

In embodiments of the present invention wherein a single heater also is used to thermally actuate the microelectromechanical actuator, the step of again melting the thermoplastic material may be performed by applying power to the heater that is sufficient to melt the thermoplastic material, but is insufficient to actuate the thermally actuated microelectromechanical actuator. The actuator thereby can deactuate or retract. In alternative embodiments wherein first and second heaters are used as described above, the step of again melting the thermoplastic material may be embodied by applying power to the first heater to melt the thermoplastic material without applying power to the second heater.

Accordingly, lockable microelectromechanical actuators including lockable thermal arched beam microelectromechanical actuators, may be provided. These actuators need not consume power to remain actuated and need not rely on mechanical friction to maintain actuation. Thermoplastic materials also may be used to produce lockable large scale actuators that are not microelectromechanical actuators.

### Brief Description of the Drawings

Figure 1A is a perspective view of embodiments of lockable thermal arched beam microelectromechanical actuators according to the present invention in an unactuated position.
Figure 2A is a side cross-sectional view along line 2A-2A' of Figure 1A.

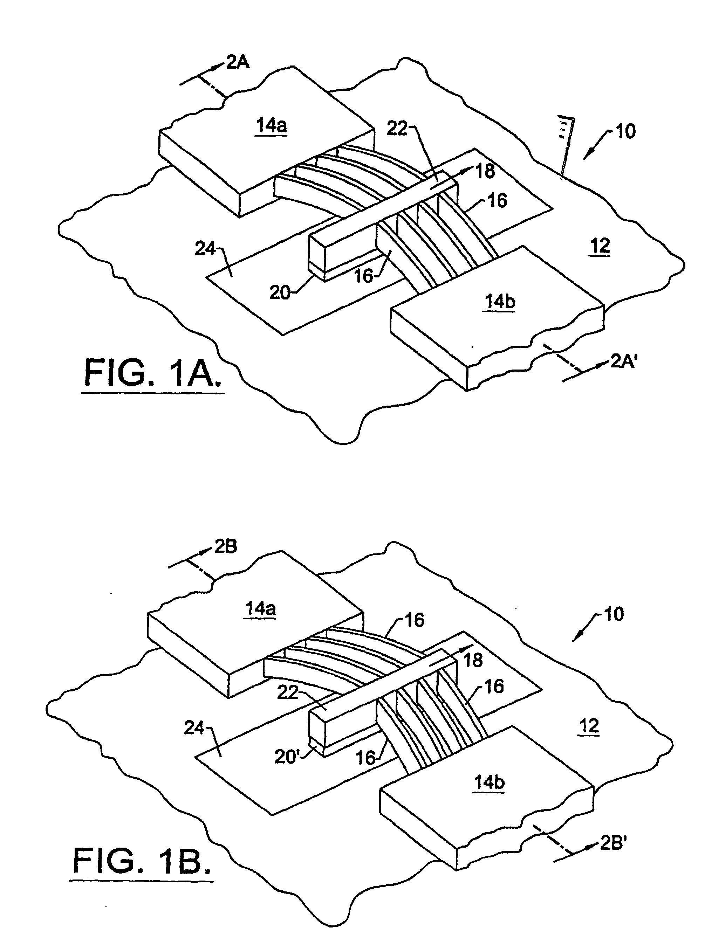

Figure 1B is a perspective view of embodiments of lockable thermal arched beam microelectromechanical actuators according to the present invention in an actuated position.

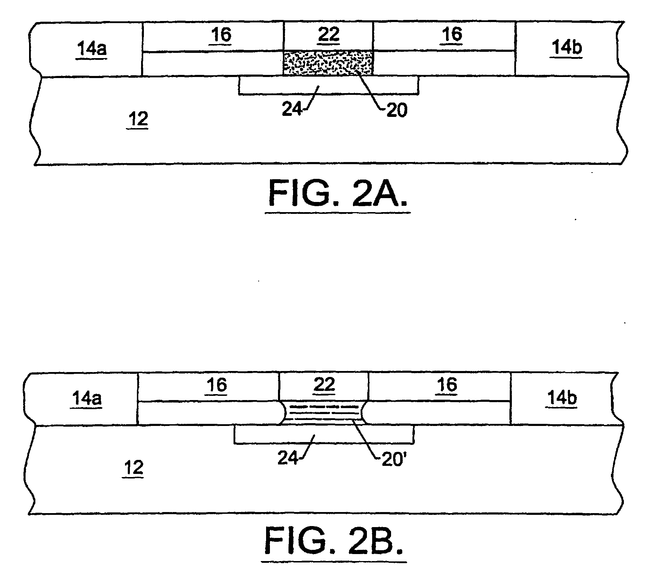

Figure 2A is a side cross-sectional view along line 2B-2B' of Figure 1B.
Figure 3A is a perspective view of other embodiments of lockable microelectromechanical actuators according to the present invention in an unlocked and open position.

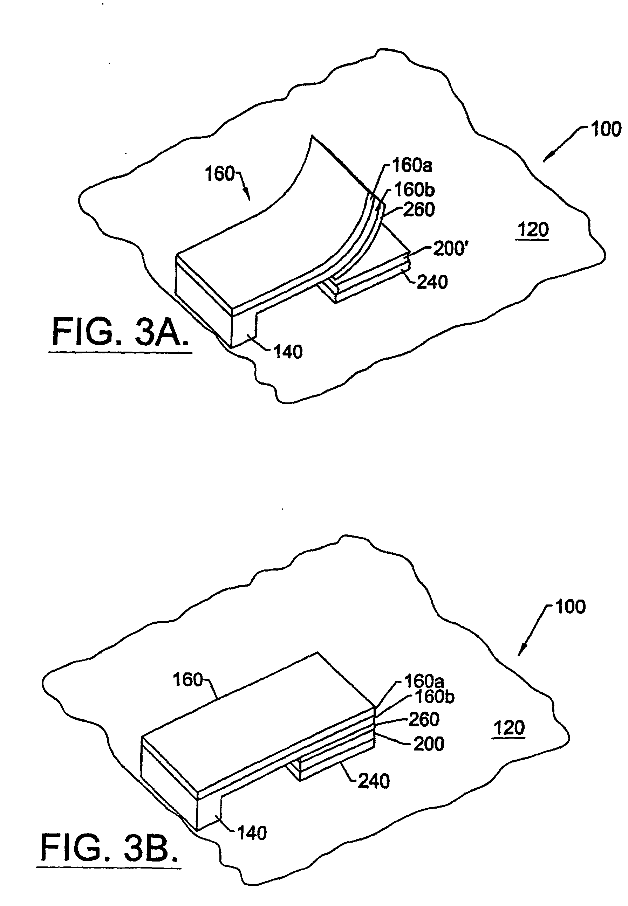

Figure 3B is a perspective view of other embodiments of lockable microelectromechanical actuators according to the present invention in a locked and closed position.

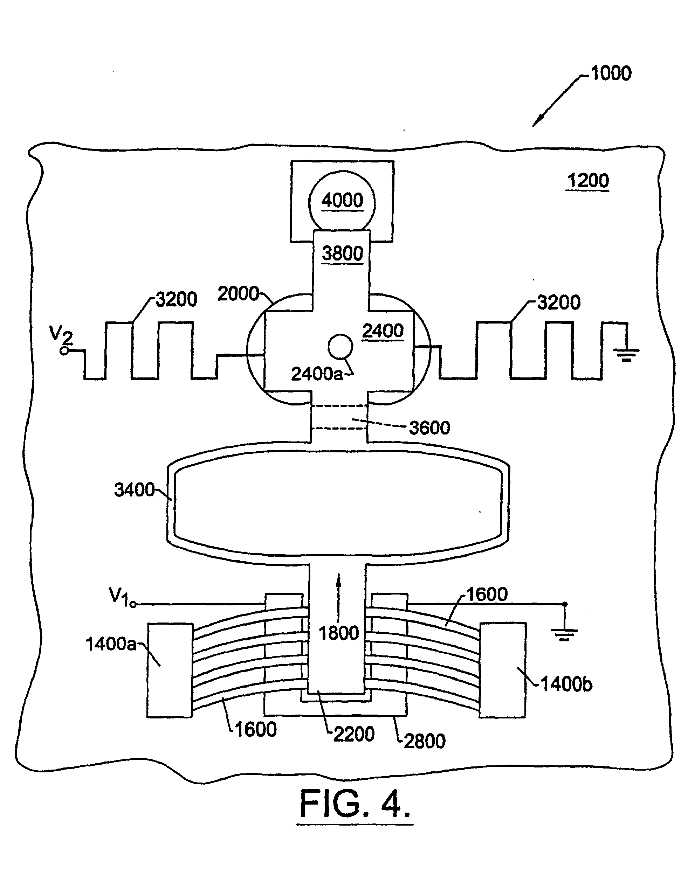

Figure 4 is a top view of other embodiments of the lockable thermal arched beam microelectromechanical actuators according to the present invention.

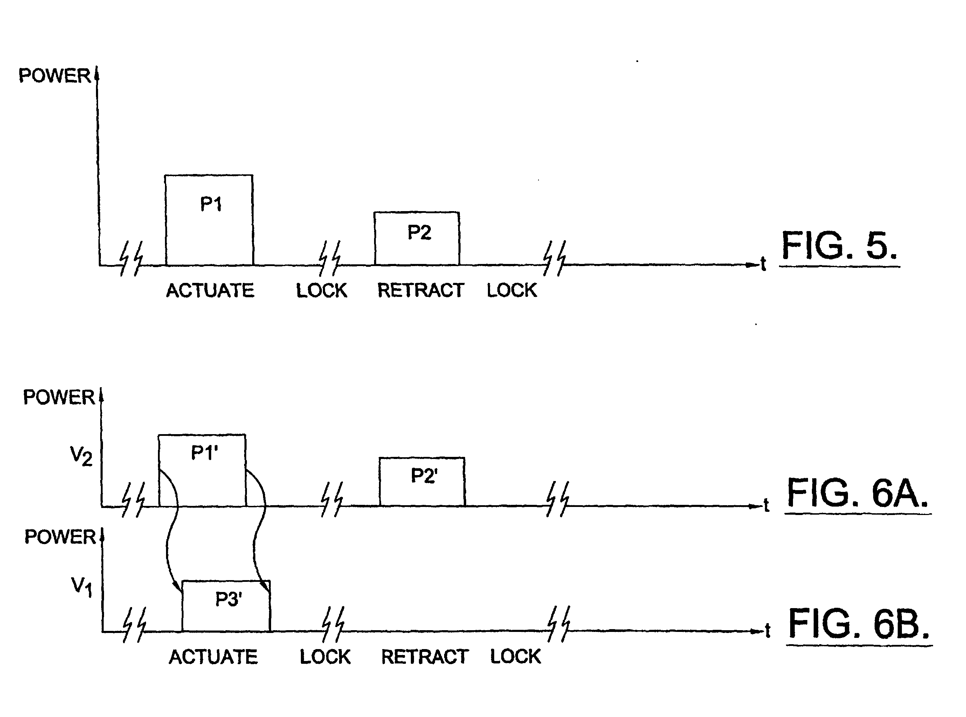

Figures 5, 6A and 6B are timing diagrams that illustrate embodiments of actuation, retraction and locking of microelectromechanical actuators according to the present invention

### Detailed Description of Preferred Embodiments

The present invention now will be described more fully hereinafter with reference to the accompanying drawings, in which preferred embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. In the drawings, the thickness of layers and regions are exaggerated for clarity. Like numbers refer to like elements throughout. It will be understood that when an element such as a layer, region or substrate is referred to as being "on", "connected to" or "coupled to" another element, it can be directly on, directly connected to or directly coupled to the other element, or intervening elements also may be present. In contrast, when an element is referred to as being "directly on", "directly connected to" or "directly coupled to" another element, there are no intervening elements present.

Referring now to Figures 1A and 2A, a perspective view and a side cross-sectional view along line 2A-2A' of first embodiments of lockable thermal arched beam microelectromechanical actuators according to the present invention in an unactuated, retracted or neutral position, are shown. As shown in Figures 1A and 2A, embodiments of lockable thermal arched microelectromechanical actuators **10** include a substrate **12,** such as a silicon semiconductor substrate, spaced apart supports **14a** and **14b** on the substrate, and one or more arched beams **16** that extend between the 2 spaced apart supports **14a** and **14b** and that further arch upon application of heat 3 thereto in the direction shown by arrow **18** for movement along the substrate **12.** It 4 will be understood that a single arched beam **16** may be used. In alternative embodiments, a plurality of arched beams **16,** such as four arched beams **16** in Figures 1A and 2A, may be used, that are coupled to common supports and/or individual 7 supports. As used herein, any reference to a beam also shall include multiple beams, and any reference to multiple beams also shall include a single beam. A coupler may be attached to the arched beams **16,** such that the arched beams **16** move in tandem along the substrate **12** upon application of heat thereto. As described in the above-cited U.S. Patents 5,909,078, 5,955,817, 5,962,949, 5,994,816 and 6,023,121, heat may be applied to the arched beams **16** by passing current through the beams and/or by an external heater. The design and operation of thermal arched beams as described in this paragraph are well known to those having skill in the art and need not be described further herein.

Still referring to Figures 1A and 2A, a thermoplastic material **20** is coupled to the arched beam **16** to lock the arched beam. A heater **24** also is provided that melts the thermoplastic material, to allow movement of the arched beam. The heater **24** may be provided on the substrate **12** as illustrated. In other embodiments, the heater may be coupled to the arched beams **16** and/or the coupler **22,** to move with movement of these elements.

In preferred embodiments illustrated in Figure 1A, the heater **24** is on the substrate **12,** and the arched beams **16** are adjacent and spaced apart from the heater. The thermoplastic material is between the heater and the arched beams **16**. More preferably, as shown in Figure 1A, the thermoplastic material is between the coupler **22** and the heater **24.**

The thermoplastic material **20** may be formed between the coupler 22 and the heater **24** by forming the thermoplastic material **20** on the heater prior to forming the coupler **22** thereon. Alternatively, a solid thermoplastic material may be placed adjacent the gap (such as a 1µm gap) between the heater **24** and the coupler **22** after fabrication of the coupler **22.** The heater **24** then may be activated to melt the thermoplastic material **20,** and allow it to creep between the heater **24** and coupler **22** by capillary action.

As is well known to those having skill in the art, a thermoplastic material becomes soft (liquid) when heated and hard (solid) when cooled. Thermoplastic materials also may be referred to herein as Phase-Change Materials (PCM). Many thermoplastic materials are known to those having skill in the art and may be used in embodiments of the present invention. For example, a thermoplastic polymer may be used. An example of a thermoplastic polymer that may be used is Crystalbond™ 509, marketed by Aremco Products, Inc., Valley Cottage, NY. As described in the Aremco Products web site, www.aremco.com, Crystalbond™ 509 is a washaway adhesive that may be used to temporarily mount products that require dicing, polishing and/or other machining processes. These adhesives can exhibit high bond strength and adhere readily to metals, glass and ceramics. Crystalbond™ 509 has a flow point of 250°F (121°C) and a viscosity of 6000 cps. Another example of a thermoplastic polymer that may be used is polyethylene glycol, which is widely available in various molecular weights. As is known to those having skill in the art, the melting temperature of polyethylene glycol can be a function of the molecular weight, so that a variety of melting points may be selected for various applications. Thermoplastic monomers also may be used.

The thermoplastic material preferably should be selected so that it remains in solid form in the range of ambient temperatures over which the microelectromechanical actuator may be used, yet can be melted at a temperature range that is slightly higher than the highest ambient temperature in which the microelectromechanical actuator may be used. The thermoplastic material preferably should melt over a narrow temperature range. The thermoplastic material also preferably should wet to the thermal arched beam **16** and/or the coupler **22** to which it is coupled. Thus, when the thermal arched beams and/or coupler are nickel, the thermoplastic material preferably should wet to nickel. The thermoplastic material also preferably should not wet to the heater **24** so that it can move with the thermal arched beam and/or coupler upon actuation thereof. Thus, when the heater **24** comprises polysilicon, the thermoplastic material preferably should not wet to polysilicon.

In higher temperature embodiments, solder may be used as a thermoplastic material **20.** For example, conventional lead-tin eutectic solder may have a melting point of about 240°C. Other thermoplastic materials may be used, depending upon the ambient temperature, the materials associated with the microelectromechanical actuator, and/or other factors.

Referring again to Figures 1A and 2A, embodiments of lockable arched beam microelectromechanical actuators are shown in their unactuated, neutral, return or retracted position. In this position, the thermoplastic material **20** preferably is maintained in solid form by not applying heat thereto from heater **24.** Thus, chatter or other movement of the actuator **10** may be prevented.

Figures 1B and 2B are a perspective view and a side cross-sectional view along the lines 2B-2B', of embodiments of lockable arched beam microelectromechanical actuators in a locked and actuated position. In order to actuate actuators of Figures 1A and 2A into the actuated position of Figures 1B and 2B, sufficient heat is applied to heater **24** to melt the thermoplastic material **20.** Sufficient heat also is applied to thermal arched beams **16,** to further arch the beams **16** in the direction **18** for movement along the substrate **12.** This heat may be applied using heater 24, using another external heater and/or by passing current through the beams **16** themselves. The melted or plastic form of the thermoplastic material is designated 20' in Figures 1B and 2B, and is illustrated with a meniscus that is typical of a liquid material that is coupled between the surfaces of the coupler **22** and the heater **24.**

Upon removal of power from the heater **24** while the actuator is actuated in the position shown in Figures 1B and 2B, the thermoplastic material solidifies, thus maintaining the actuator at or near its actuated position shown in Figures 1B and 2B. Thus, notwithstanding removal of power from the heater **24,** from an external heater and/or termination of the current in the beam or beams **16**, the actuator may remain at or near its actuated position.

Still referring to Figures 1A, 1B, 2A and 2B, when a single heater **24** is used to both actuate the thermal arched beam microelectromechanical actuator and to melt the thermoplastic material **20,** unexpected results may be obtained. A first unexpected result is that when power is removed from the heater, the thermoplastic material can solidify fast enough to lock the actuator in the actuated position shown in Figures 1B and 2B. A small amount of retraction may take place, but the thermoplastic material solidifies quickly enough so that the actuator remains at or near its most recent position shown in Figures 1B and 2B. In other to reduce or eliminate this small amount of retraction, current may be passed through a subset of the thermal arched beams in order to retain the thermal arched beams in the actuated position while the thermoplastic material solidifies.

Another unexpected result is that the actuator can be returned to or near its unactuated or neutral position of Figures 1A and 2A from its actuated position of Figures 1B and 2B, by applying sufficient heater current to heater **24** to melt the thermoplastic material, but not enough current to thermally actuate the actuator. Thus, the heater **24** may be configured to melt the thermoplastic material **20** and actuate the thermal arched beam upon application of a first amount of power thereto, and to melt the thermoplastic material without actuating the thermal arched beam upon application of a second amount of power thereto that is less than the first amount of power.

In specific embodiments, it has been found that six volts and 25 mA may be applied to a heater **24** for 10 ms to melt the thermoplastic material **20** and to actuate the actuator **10**. Upon removal of this power, the thermoplastic material solidifies so that the actuator remains in its actuated position. Continuing with this embodiment, to reset the actuator, 15 mA may be applied to the heater **24** at 4V for about 15 ms. This power is sufficient to melt the thermoplastic material **20,** but is insufficient to cause the thermal arched beam to remain actuated. Thus, the actuator may be restored. Upon removal of this power, the actuator may be maintained in its restored position when the thermoplastic material solidifies.

Figures 3A and 3B illustrate alternate embodiments of lockable microelectromechanical actuators according to the present invention. These embodiments illustrate lockable, out-of-plane, bimorph, cantilever thermal microelectromechanical actuators. It also will be understood that other microelectromechanical actuators including thermal, magnetic, electrostatic, in-plane and/or out-of-plane actuators may be provided.

Figure 3A is a perspective view illustrating embodiments of bimorph cantilever actuators in an unlocked and open position and Figure 3B illustrates embodiments of bimorph cantilever beam thermal actuators in a locked and closed position. Referring to Figure 3A, these embodiments of lockable thermal actuators **100** include a substrate **120,** such as a silicon semiconductor substrate, a support **140** and a cantilever beam **160** that comprises two bimorph materials **160a** and **160b.** The bimorph materials **160a** and **160b** are configured such that when the bimorph cantilever beam **160** is not heated, it remains in the open position shown in Figure 3A. A heater **240** may be provided to melt a thermoplastic material. The melted thermoplastic material is indicated in Figure 3A by **200'.** Thus, upon application of heat to the heater **240,** the thermoplastic material **200'** melts, and the cantilevered beam **160** is allowed to retract to its retracted or neutral position shown in Figure 3A.

Referring now to Figure 3B, the cantilevered bimorph beam **160** is actuated by heating the cantilevered bimorph beam **160**, for example by passing current therethrough and/or by using an external heater. Power then is removed from the heater **240,** to allow the thermoplastic material **200** to solidify, thereby locking the bimorph cantilever beam **160** in its actuated position of Figure 3B. Simultaneously, or thereafter, heating of the cantilever bimorph beam **160b** may be terminated, so that no additional power need be consumed. It may be desirable to provide a thermal isolator **260** between the cantilever bimorph beam and the thermoplastic material **200,** to thermally isolate the heated bimorph beam **160** from the heater **240**. Thus, when power is removed from the heater **240,** the heating of the beam **160** will not allow the thermoplastic material **200** to stay melted, but rather will allow the thermoplastic material **200** to solidify. Thermal isolators **260** may comprise silicon dioxide, silicon nitride and/or other materials with relatively low thermal conductivity. Other thermal isolator structures also may be provided.

Figure 4 is a top view of other embodiments of lockable thermal arched beam microelectromechanical actuators according to the present invention. These embodiments employ separate heaters to actuate the thermal actuator and to melt the thermoplastic material. By providing separate heaters, more accurate positioning of an actuator may be obtained.

As shown in Figure 4, these embodiments of lockable thermal arched beam microelectromechanical actuators **1000** include a substrate **1200**, such as a silicon semiconductor substrate, spaced apart supports **1400a** and **1400b** on the substrate, and one or more arched beams **1600** that extend between the spaced apart supports **1400a** and **1400b** and that further arch upon application of heat thereto, for movement along the substrate in the direction shown by arrow **1800.** In Figure 4, multiple arched beams **1600** are coupled via a coupler **2200.** The thermal arched beams **1600** are heated by application of a voltage **V**_{**1**} across a pair of terminals that are coupled to a heater **2800.**

Another heater **2400** may be mechanically coupled to the coupling member **2200,** so that it moves along with the coupling member **2200.** The heater **2400** will be referred to herein as a first heater and the heater **2800** will be referred to herein as a second heater. A second voltage **V**_{**2**} may be applied across the first heater **2400** using flexible wires **3200.** The flexible wires **3200** also may provide mechanical stability for the actuator. In alternative embodiments, the first heater **2400** may be directly on the substrate and need not move with the actuator.

A thermoplastic material **2000** is provided between the heater **2400** and the substrate **1200**. Upon application of a voltage **V**_{**2**} between the flexible wires **3200,** the thermoplastic material may be melted. An aperture **2400a** may be provided in the heater **2400**, to allow the thermoplastic material to be placed between the heater **2400** and the substrate **1200,** by heating the heater **2400** and allowing the thermoplastic material to flow through the aperture **2400a,** to between the heater **2400** and the substrate **1200** by capillary action. In alternative fabrication methods, the thermoplastic material **2000** may be fabricated on the substrate **1200** prior to fabricating the beams **1600**, coupling member **2200** and heater **2400** above the substrate.

Still referring to Figure 4, an isolation member **3400** also may be provided. The isolation member **3400** can act as a mechanical shock absorber, and also can thermally isolate the first heater **2400** from the second heater **2200**, to allow independent control thereof. In alternative embodiments, thermal isolation or additional thermal isolation may be provided by a low thermal conductivity member **3600** that is placed between the first heater **2400** and the second heater **2800.** The low thermal conductivity member **3600** may comprise, for example, silicon dioxide and/or silicon nitride. Other thermal and/or mechanical isolators may be provided.

Since two separate heaters **2400** and **2800** are employed in embodiments of Figure 4, separate control of the melting of thermoplastic material **2000** and actuation of the thermal arched beams **1600** may be provided. Precise positioning of a movable member **3800** thereby may be provided. For example, as shown in Figure 4, an optical fiber and/or an aperture **4000** may be coupled to and/or formed in the substrate **1200.** Precise positioning of movable member **3800** over the aperture/fiber **4000** may be provided, to thereby provide precise metering of a fluid and/or precise attenuation of optical energy.

In particular, a variable voltage **V**_{**1**} may be applied to the second heater **2800,** to position the movable member **3800** while also applying sufficient voltage **V**_{**2**} to the heater **2400** to melt the thermoplastic material **2000.** Then, when a desired position is obtained, the voltage **V**_{**2**} may be withdrawn so that the thermoplastic material **2000** solidifies. The voltage **V**_{**1**} then may be withdrawn from the heater **2800.** Thus, retraction of the movable member **3800** may be prevented so that precise positioning may be obtained in a variable position device. It will be understood that the movable member also may be coupled to relay contacts, variable circuit elements such as variable resistors, capacitors and/or inductors, temperature reactive devices such as 16 circuit breakers and/or other elements for actuation and positioning by embodiments of microelectromechanical actuators according to the present invention.

Referring now to Figures 5, 6A and 6B, embodiments of methods of operating microelectromechanical actuators according to the present invention now will be described. In general, method embodiments of the present invention melt a thermoplastic material that is coupled to a microelectromechanical actuator to unlock the microelectromechanical actuator, and actuate the unlocked microelectromechanical actuator. Melting and actuating may take place simultaneously. The melted thermoplastic material then is allowed to solidify to lock the microelectromechanical actuator in an actuated position. The thermoplastic material then may be melted again to unlock and deactuate the microelectromechanical actuator.

Figure 5 is a timing diagram that illustrates actuation, retraction and locking of microelectromechanical actuators that use a single heater, such as embodiments of Figures 1A-2B. As shown in Figure 5, in order to actuate the heater, a first pulse **P1** of a first power is applied to the heater **24.** The power of pulse **P1** preferably is sufficient to melt the thermoplastic material **20** and to actuate thermal arched beam **16.** For example, a pulse **P1** of 25 mA at 6 V for 10 ms may be applied. Thus, melting of the thermoplastic material **20** and actuation of the thermal arched beam **16** may occur simultaneously. Thereafter, to lock the actuator in the actuated position, the pulse **P1** is terminated. The thermoplastic material solidifies and acts like a glue. As was described above, a small amount of retraction may take place until the thermoplastic material solidifies.

Continuing with the description of Figure 5, in order to retract the actuator, a second pulse **P2** is applied that is of lower power than the first pulse **P1.** For example, 15 mA at 4V for 15 ms may be applied. Preferably, pulse **P2** has power that is sufficiently high to melt the thermoplastic material **20,** but is sufficiently low to prevent actuation of the actuator. Upon removal of the lower power pulse **P2,** the actuator is locked in the retracted position.

A surprising and unexpected result is that when power is removed from the heater by terminating pulse **P1,** the thermoplastic material solidifies fast enough to lock the actuator in its new position. A further unexpected result is that the actuator can be restored to its starting position by applying the pulse **P2** that has enough heater power to melt the thermoplastic material but not enough to move the actuator. With the thermoplastic material melted, viscous flow can occur and permit the actuator to relax back to its neutral position.

The time scale for the phase change transitions has been found to be compatible with the mechanical response of thermal arched beam microelectromechanical actuators. This can provide a reversible system with continuous variability and allow a relatively simple control setup. Latching and unlatching may be accomplished by high and low power signals **P1** and **P1** respectively, across the same control inputs. Bistable operation thus may be achieved while allowing a simple control scheme. Reliability of at least 20,000 switch cycles presently has been obtained during testing, without degradation in electrical performance. Other thermoplastic materials may be selected to tailor the specific phase change temperature and the viscosity of the liquid phase according to device requirements.

Figures 6A and 6B are timing diagrams illustrating methods of operating microelectromechanical actuators that employ first and second heaters, such as the embodiments of Figure 4. As shown in Figures 6A **and** 6B, in order to actuate the actuator, a voltage pulse **P1'** is applied to terminal **V**_{**2**}**,** to melt the thermoplastic material **2000.** After the thermoplastic material **2000** is melted, a pulse **P3'** is applied to terminal **V**_{**1**} to actuate the actuator to a desired position. When the actuator has reached its desired position, the pulse **P1'** is terminated, to thereby solidify the thermoplastic material **2000.** The pulse **P3'** then may be terminated. It will be understood that since the pulses **P1'** and **P3'** are applied to separate heaters via separate terminals **V**_{**2**} and **V**_{**1**}**,** the pulses **P1'** and **P3'** may include a wide range of voltage, current and/or time parameters that need not be related to one another.

Continuing with the description of Figures 6A and 6B, in order to retract the actuator, a second pulse **P2'** may be applied to terminal **V**_{**2**}**,** to again melt the thermoplastic material **2000.** This pulse may have a different voltage, current and/or power compared to pulse **P1'** or they may be identical, because pulse **P2'** can be independent of actuation of the actuator. High precision positioning thereby may be obtained.

In the drawings and specification, there have been disclosed typical preferred embodiments of the invention and, although specific terms are employed, they are used in a generic and descriptive sense only and not for purposes of limitation, the scope of the invention being set forth in the following claims.

## Claims

1. A lockable microelectromechanical actuator including a microelectromechanical actuator (22), **CHARACTERIZED BY**:
a thermoplastic material (20) that is coupled to the microelectromechanical actuator to lock the microelectromechanical actuator; and
a heater (24) that is configured to melt the thermoplastic material to allow movement of the microelectromechanical actuator.

2. A lockable microelectromechanical actuator according to Claim 1
**CHARACTERIZED BY**:
the microelectromechanical actuator being a thermally actuated microelectromechanical actuator that is configured to move in response to thermal actuation.

3. A lockable microelectromechanical actuator according to Claim 2 wherein the heater is a first heater (2400), the lockable microelectromechanical actuator further **CHARACTERIZED BY** a second heater (2800) that is thermally coupled to the microelectromechanical actuator such that the microelectromechanical actuator moves in response to actuation of the second heater.

4. A lockable microelectromechanical actuator according to Claim 3 further **CHARACTERIZED BY** a thermal isolator (3400) that is configured to thermally isolate the second heater from the thermoplastic material.

5. A lockable microelectromechanical actuator according to Claims 1, 2, 3 or 4 wherein the heater or first heater is further **CHARACTERIZED BY** being configured to melt the thermoplastic material and actuate the thermal actuator upon application of a first amount of power (P1) thereto and being configured to melt the thermoplastic material without actuating the thermal actuator upon application of a second amount of power (P2) thereto that is less than the first amount of power.

6. A lockable microelectromechanical actuator according to Claims 1, 2, 3 or 4 further **CHARACTERIZED BY** at least one of a relay contact, an optical attenuator, an optical switch, a variable circuit element, a valve and a circuit breaker that is mechanically coupled to the microelectromechanical actuator for actuation thereby.

7. A method of operating a microelectromechanical actuator
**CHARACTERIZED BY**:
melting a thermoplastic material that is coupled to the microelectromechanical actuator to unlock the microelectromechanical actuator;
actuating the unlocked microelectromechanical actuator; and
allowing the melted thermoplastic material to solidify to lock the microelectromechanical actuator.

8. A method according to Claim 7 further **CHARACTERIZED BY** the steps of melting and actuating being performed simultaneously.

9. A method according to Claims 7 or 8:
wherein the microelectromechanical actuator is further **CHARACTERIZED BY** a heater that is thermally coupled to the thermoplastic material;
wherein the melting step is further **CHARACTERIZED BY** the step of applying power to the heater to melt the thermoplastic material; and
wherein the allowing step is further **CHARACTERIZED BY** the step of reducing the power to the heater to allow the melted thermoplastic material to solidify.

10. A method according to Claims 7 or 8:
wherein the microelectromechanical actuator is further **CHARACTERIZED BY** a first heater (2400) that is thermally coupled to the thermoplastic material;
wherein the microelectromechanical actuator is a thermally actuated microelectromechanical actuator;
wherein the microelectromechanical actuator is further **CHARACTERIZED BY** a second heater (2800) that is thermally coupled to the thermally actuated microelectromechanical actuator;
wherein the melting step is further **CHARACTERIZED BY** the step of applying power to the first heater to melt the thermoplastic material;
wherein the actuating step is further **CHARACTERIZED BY** the step of applying power to the second heater to actuate the thermally actuated microelectromechanical actuator; and
wherein the allowing step is further **CHARACTERIZED BY** the step of reducing the power to the heater to allow the melted thermoplastic material to solidify.

## Patentansprüche

1. Sperrbarer mikroelektromechanischer Aktor mit einem mikroelektromechanischen Aktor (22), **gekennzeichnet durch** ein thermoplastisches Material (20), das mit dem mikroelektromechanischen Aktor verbunden ist, um den mikroelektromechanischen Aktor zu sperren, und eine Heizvorrichtung (24) zum Schmelzen des thermoplastischen Materials, um die Bewegung des mikroelektromechanischen Aktors zuzulassen.

2. Sperrbarer mikroelektromechanischer Aktor nach Anspruch 1, **dadurch gekennzeichnet, dass** der mikroelektromechanische Aktor ein thermisch betätigter mikroelektromechanischer Aktor ist, der konfiguriert ist, um sich in Reaktion auf eine thermische Betätigung zu bewegen.

3. Sperrbarer mikroelektromechanischer Aktor nach Anspruch 2, bei dem die Heizvorrichtung eine erste Heizvorrichtung (2400) ist, wobei der sperrbare mikroelektromechanische Aktor ferner durch eine zweite Heizvorrichtung (2800) gekennzeichnet ist, die thermisch mit dem mikroelektromechanischen Aktor verbunden ist, sodass der mikroelektromechanische Aktor sich in Reaktion auf die Betätigung der zweiten Heizvorrichtung bewegt.

4. Sperrbarer mikroelektromechanischer Aktor nach Anspruch 3, ferner **gekennzeichnet durch** einen Wärmeisolator (3400) zum thermischen Isolieren der zweiten Heizvorrichtung gegen das thermoplastische Material.

5. Sperrbarer mikroelektromechanischer Aktor nach Anspruch 1, 2, 3 oder 4, bei dem die Heizvorrichtung oder erste Heizvorrichtung ferner **dadurch gekennzeichnet ist, dass** sie konfiguriert ist, um bei Anlegen eines ersten Leistungsbetrags (P1) daran das thermoplastische Material zu schmelzen und den thermischen Aktor zu betätigen, und dass sie konfiguriert ist, um bei Anlegen eines zweiten Leistungsbetrags (P2) daran, der kleiner als der erste Leistungsbetrag ist, das thermoplastische Material ohne Betätigen des thermischen Aktors zu schmelzen.

6. Sperrbarer mikroelektromechanischer Aktor nach Anspruch 1, 2, 3 oder 4, ferner **gekennzeichnet durch** wenigstens eines/einen der Folgenden: einen Relaiskontakt, ein optisches Dämpfungsglied, einen optischen Schalter, ein veränderbares Schaltkreiselement, ein Ventil und einen Unterbrecher, der/das mechanisch mit dem mikroelektromechanischen Aktor verbunden ist zur Betätigung hierdurch.

7. Verfahren für den Betrieb eines mikroelektromechanischen Aktors, **gekennzeichnet durch** Schmelzen eines thermoplastischen Materials, das mit dem mikroelektromechanischen Aktor verbunden ist, um den mikroelektromechanischen Aktor zu entsperren; Betätigen des entsperrten mikroelektromechanischen Aktors und Erstarrenlassen des geschmolzenen thermoplastischen Materials zum Sperren des mikroelektromechanischen Aktors.

8. Verfahren nach Anspruch 7, ferner **dadurch gekennzeichnet, dass** die Schmelz- und Betätigungsschritte gleichzeitig durchgeführt werden.

9. Verfahren nach Anspruch 7 oder Anspruch 8, bei dem der mikroelektromechanische Aktor ferner **gekennzeichnet ist durch** eine Heizvorrichtung, die thermisch mit dem thermoplastischen Material verbunden ist; bei dem der Schmelzschritt ferner **gekennzeichnet ist durch** den Schritt des Anlegens von Leistung an die Heizvorrichtung zum Schmelzen des thermoplastischen Materials und bei dem der Schritt des Erstarrenlassens ferner **gekennzeichnet ist durch** den Schritt des Verringerns der zur Heizvorrichtung zugeführten Leistung, um das geschmolzene thermoplastische Material erstarren zu lassen.

10. Verfahren nach Anspruch 7 oder Anspruch 8, bei dem der mikroelektromechanische Aktor ferner **gekennzeichnet ist durch** eine erste Heizvorrichtung (2400), die thermisch mit dem thermoplastischen Material verbunden ist; bei dem der mikroelektromechanische Aktor ein thermisch betätigter mikroelektromechanischer Aktor ist; bei dem der mikroelektromechanische Aktor ferner **gekennzeichnet ist durch** eine zweite Heizvorrichtung (2800), die mit dem thermisch betätigten mikroelektromechanischen Aktor thermisch verbunden ist; bei dem der Schmelzschritt ferner **gekennzeichnet ist durch** den Schritt des Anlegens von Leistung an die erste Heizvorrichtung zum Schmelzen des thermoplastischen Materials; bei dem der Betätigungsschritt ferner **gekennzeichnet ist durch** den Schritt des Anlegens von Leistung an die zweite Heizvorrichtung, um den thermisch betätigten mikroelektromechanischen Aktor zu betätigen, und bei dem der Schritt des Erstarrenlassens ferner **gekennzeichnet ist durch** den Schritt des Verringerns der zur Heizvorrichtung zugeführten Leistung, um das geschmolzene thermoplastische Material erstarren zu lassen.

## Revendications

1. Actionneur microélectromécanique verrouillable comprenant un actionneur microélectromécanique (22), **caractérisé par** :
un matériau thermoplastique (20) qui est couplé à l'actionneur microélectromécanique pour verrouiller l'actionneur microélectromécanique, et
un élément chauffant (24) qui est configuré pour faire fondre le matériau thermoplastique pour permettre le déplacement de l'actionneur microélectromécanique.

2. Actionneur microélectromécanique verrouillable suivant la revendication 1,
**caractérisé par** :
l'actionneur microélectromécanique étant un actionneur microélectromécanique actionné thermiquement qui est configuré pour se déplacer en réaction à l'actionnement thermique.

3. Actionneur microélectromécanique verrouillable suivant la revendication 2,
dans lequel l'élément chauffant est un premier élément chauffant (2400), l'actionneur microélectromécanique verrouillable étant en outre **caractérisé par** un deuxième élément chauffant (2800) qui est thermiquement couplé à l'actionneur microélectromécanique de telle sorte que l'actionneur microélectromécanique se déplace en réaction à l'actionnement du deuxième élément chauffant.

4. Actionneur microélectromécanique verrouillable suivant la revendication 3, **caractérisé en outre par** un isolateur thermique (3400) qui est configuré pour isoler thermiquement le deuxième élément chauffant du matériau thermoplastique.

5. Actionneur microélectromécanique verrouillable suivant la revendication 1, 2, 3 ou 4, dans lequel l'élément chauffant ou premier élément chauffant est en outre **caractérisé en ce qu'**il est configuré pour faire fondre le matériau thermoplastique et actionner l'actionneur thermique lors de l'application d'une première quantité de puissance (P1) sur celui-ci et est configuré pour faire fondre le matériau thermoplastique sans actionner l'actionneur thermique lors de l'application d'une deuxième quantité de puissance (P2) sur celui-ci qui est inférieure à la première quantité de puissance.

6. Actionneur microélectromécanique verrouillable suivant la revendication 1, 2, 3 ou 4, **caractérisé en outre par** au moins un contact de relais, un atténuateur optique, un interrupteur optique, un élément de circuit variable, une valve et/ou un disjoncteur qui est mécaniquement couplé à l'actionneur microélectromécanique pour un actionnement par ce moyen.

7. Procédé pour faire fonctionner un actionneur microélectromécanique, **caractérisé par** les étapes suivantes :
faire fondre le matériau thermoplastique qui est couplé à l'actionneur microélectromécanique pour déverrouiller l'actionneur microélectromécanique ;
actionner l'actionneur microélectromécanique déverrouillé, et
permettre au matériau thermoplastique fondu de se solidifier pour verrouiller l'actionneur microélectromécanique.

8. Procédé suivant la revendication 7, **caractérisé en outre en ce que** les étapes de fusion et d'actionnement sont exécutées simultanément.

9. Procédé suivant la revendication 7 ou 8 :
dans lequel l'actionneur microélectromécanique est en outre **caractérisé par** un élément chauffant qui est thermiquement couplé au matériau thermoplastique ;
dans lequel l'étape de fusion est en outre **caractérisée par** l'étape d'application de puissance à l'élément chauffant pour faire fondre le matériau thermoplastique, et
dans lequel l'étape de permission est en outre **caractérisée par** l'étape de réduction de la puissance appliquée à l'élément chauffant pour permettre au matériau thermoplastique fondu de se solidifier.

10. Procédé suivant la revendication 7 ou 8 :
dans lequel l'actionneur microélectromécanique est en outre **caractérisé par** un premier élément chauffant (2400) qui est thermiquement couplé au matériau thermoplastique ;
dans lequel l'actionneur microélectromécanique est un actionneur microélectromécanique actionné thermiquement ;
dans lequél l'actionneur microélectromécanique est en outre **caractérisé par** un deuxième élément chauffant (2800) qui est thermiquement couplé à l'actionneur microélectromécanique actionné thermiquement ;
dans lequel l'étape de fusion est en outre **caractérisée par** l'étape d'application de puissance au premier élément chauffant pour faire fondre le matériau thermoplastique ;
dans lequel l'étape d'actionnement est en outre **caractérisée par** l'étape d'application de puissance au deuxième élément chauffant pour actionner l'actionneur microélectromécanique actionné thermiquement, et
dans lequel l'étape de permission est en outre **caractérisée par** l'étape de réduction de la puissance appliquée à l'élément chauffant pour permettre au matériau thermoplastique fondu de se solidifier.
